# EUROPÄISCHE PATENTSCHRIFT

(11) **EP 3 465 328 B1**
(45) Veröffentlichungstag und Bekanntmachung des Hinweises auf die Patenterteilung: **30.04.2025**
(21) Anmeldenummer: 17726903.2
(22) Anmeldetag: 24.05.2017
(51) Int. Cl.: H01L 25/075, H05K 1/11, G02B 27/01, H01L 33/64, H05K 1/02

(54) **LICHTERZEUGUNGSVORRICHTUNG FÜR EINE KOPF-OBEN-ANZEIGE EINES KRAFTFAHRZEUGS**
LIGHT SOURCE FOR AUTOMOBILE HEAD UP DISPLAY
DISPOSITIF DE GÉNÉRATION DE LUMIÈRE POUR UN AFFICHAGE TÊTE HAUTE D'UN VÉHICULE AUTOMOBILE

(30) Priorität: 31.05.2016 DE 102016109951
(43) Veröffentlichungstag der Anmeldung: 10.04.2019
(73) Patentinhaber: Valeo Schalter und Sensoren GmbH, 74321 Bietigheim-Bissingen (DE)
(72) Erfinder: POSLOWSKY, Georg, 74321 Bietigheim-Bissingen (DE); SIMONIS, Karl, 74321 Bietigheim-Bissingen (DE)
(74) Vertreter: Pothmann, Karsten
(86) Internationale Anmeldenummer: PCT/EP2017/062526
(87) Internationale Veröffentlichungsnummer: WO 2017/207380

(56) Entgegenhaltungen:
- EP-A1- 1 553 641
- EP-A1- 1 553 641
- EP-A2- 2 211 386
- EP-A2- 2 211 386
- WO-A1-2013/190849
- WO-A1-2013/190849
- WO-A1-2015/182892
- WO-A1-2015/182892
- WO-A1-2016/061598
- WO-A1-2016/061598
- WO-A1-2016/079005
- DE-U1- 202007 015 174
- US-A1- 2002 024 821
- US-A1- 2002 024 821

## Beschreibung

Die Erfindung betrifft eine Lichterzeugungsvorrichtung für eine Kopf-oben-Anzeige eines Kraftfahrzeugs, mit einer Leiterplatte, und mit zumindest zwei mittels Leiterbahnen in Reihe geschalteten, auf einer Vorderseite der Leiterplatte in einer Reihe angeordneten Leuchtdioden, deren jeweilige Orientierung auf der Vorderseite durch eine Ausrichtung einer Kathodenseite und einer Anodenseite der jeweiligen Leuchtdiode bestimmt ist. Die Erfindung betrifft auch eine Kopf-oben-Anzeige mit solch einer Lichterzeugungsvorrichtung sowie ein entsprechendes Kraftfahrzeug.

In bekannten Kopf-oben-Anzeigevorrichtungen (Head-Up-Displays, HUDs) in Kraftfahrzeugen wird ein Spiegel genutzt, um eine Information in eine spezifische Richtung projizierend anzuzeigen. Bei diesem Spiegel kann es sich um die Windschutzscheibe oder aber um sogenannte Combinerspiegel oder Kombinierspiegel handeln, welche eine semitransparente Spiegelfläche aufweisen, durch welche ein Überlagern einer auf den Spiegel projizierten Information aus der Kopf-oben-Anzeigevorrichtung, welche von diesem reflektiert wird, mit einer durch den Spiegel hindurchscheinenden Information aus einer hinter dem Spiegel liegenden Umgebung des Kraftfahrzeugs ermöglicht. Bei einer Kopf-oben-Anzeige mit einem Kombinierspiegel (Combiner-HUD, cHUD) kann der Spiegel eingezogen oder eingeklappt werden, wenn die Anzeigevorrichtung nicht benötigt wird. Die auf den Spiegel projizierte Information wird hier mittels einer Lichtquelle beziehungsweise mittels einer Lichterzeugungsvorrichtung der Kopf-oben-Anzeigevorrichtung erzeugt. Hierfür kommen typischerweise auf einer Leiterplatte angeordnete Leuchtdioden zum Einsatz.

So zeigt beispielsweise die WO 2015/017834 A2 ein Gerät um Sammeln und Projizieren von Licht einer vorgegebenen Leuchtdichte. Dabei kann eine Linse an einem Halter befestigt werden, welcher seinerseits auf einer Leiterplatte mit Leuchtdioden angeordnet ist.

Aus der US 20120218479 A1 ist eine Beleuchtungseinheit mit einer rechteckigen Leiterplatte sowie einer Vielzahl von Lichtquellen bekannt, welche in Reihen und Spalten auf der Leiterplatte angeordnet sind und dabei in Reihen- und Zeilenrichtung elektrisch in Serie geschaltet sind. Weiterer relevanter Stand der Technik ist DE202007015174A.

Es ergibt sich die Aufgabe, eine verbesserte Lichterzeugungsvorrichtung für eine Kopf-oben-Anzeigevorrichtung eines Kraftfahrzeugs bereitzustellen, welche insbesondere eine effektivere und effizientere Lichterzeugung in der Kopf-oben-Anzeigevorrichtung realisiert.

Diese Aufgabe wird durch die unabhängigen Patentanspruche gelöst. Vorteilhafte Ausführungsformen ergeben sich aus den abhängigen Patentansprüchen, der Beschreibung und den Figuren.

Die Erfindung umfasst eine Lichterzeugungsvorrichtung für eine Kopf-oben-Anzeige bzw. Kopf-oben-Anzeigevorrichtung eines Kraftfahrzeugs. Die Lichterzeugungsvorrichtung ist insbesondere eine Lichtquelleneinrichtung für die Kopf-oben-Anzeige (HuD, Head-up-Display) bilden. Aus dem Licht der Lichterzeugungsvorrichtung wird mittels einer Bilderzeugungsvorrichtung, beispielsweise einem TFT-Display, der Kopf-oben-Anzeige ein virtuelles Bild erzeugt, welches dann auf eine Projektionsfläche projiziert wird. Sie kann auch als Beleuchtungseinrichtung bezeichnet werden. Die Lichterzeugungsvorrichtung umfasst eine Leiterplatte und zumindest zwei mittels zumindest einer Leiterbahn in Reihe geschalteten, auf einer Vorderseite der Leiterplatte in einer Reihe angeordneten Leuchtdioden, deren jeweilige Orientierung auf der Vorderseite in der Ebene der Vorderseite durch eine Ausrichtung einer Kathodenseite und einer Anodenseite der jeweiligen Leuchtdiode bestimmt ist. Bevorzugt umfasst die Lichterzeugungsvorrichtung hier eine Vielzahl von Leuchtdioden (LEDs), welche in einer geraden Reihe angeordnet und in Reihe geschaltet sind.

Hierbei sind die jeweils in der Reihenschaltung aufeinanderfolgenden Leuchtdioden geometrisch, also im Hinblick auf eine jeweilige Lage der Kathoden- und Anodenseiten der Leuchtdioden, im Wesentlichen entgegengesetzt orientiert angeordnet. Die Orientierung einer Seite oder einer Oberfläche wird hier und im Folgenden durch einen zugeordneten Normalenvektor der jeweiligen Seite oder Fläche bestimmt. Unter dem Begriff im Wesentlichen ist hier und im Folgenden eine Identität oder eine einen vorbestimmten Maximalbetrag nicht überschreitende Abweichung zu verstehen. Dieser Maximalbetrag beträgt für Winkel im Rahmen dieser Offenbarung 15 Grad, bevorzugt 8 Grad und besonders bevorzugt 3 Grad. Kathodenseite und Anodenseite können so für jede Leuchtdiode in eine verschiedene Richtungen weisen, welche je senkrecht zu einer Haupterstreckungsrichtung der Reihe der Leuchtdioden stehen. Somit ergibt sich für die Leiterbahnen zwischen zwei Leuchtdioden bei mehreren Leuchtdioden ein schlangenförmiges Muster, bei welchem beispielsweise eine Leiterbahn von einer Kathodenseite bzw. Anodenseite einer einen Leuchtdiode zunächst senkrecht zur Haupterstreckungsrichtung der Reihe der Leuchtdioden fort führt, um sodann unter einer Kurve entgegengesetzt zur zuvor eingeschlagenen Richtung zurück zur Anodenseite bzw. Kathodenseite einer nächsten Leuchtdiode zu führen.

Das hat den Vorteil, dass die vor allem im Fußbereich der Leuchtdioden durch die Leiterbahnen entstehende Wärme besonders effektiv von der jeweiligen Leuchtdiode, an welcher die Wärme entstanden ist, fortgeleitet wird. Da die Leiterbahnen an der Kathoden- beziehungsweise Anodenseite der jeweiligen Leuchtdiode senkrecht zur Haupterstreckungsrichtung der Reihe von der Leuchtdiode fortführt, wird die Wärme auch von den weiteren Leuchtdioden, welche ebenfalls Wärmequellen sind, fortgeführt. Somit wird insgesamt die Wärme aller Leuchtdioden bestmöglich in der Ebene der Leiterplatte verteilt oder gespreizt. Damit werden sogenannte Hotspots, also lokale Wärmespitzen, in der Nähe der Leuchtdioden oder in der Reiht zwischen den Leuchtdioden vermieden. Somit wird die Temperatur verbessert abgeleitet, die Lebensdauer der Leuchtdioden erhöht und ein energieeffizienterer Betrieb der Leuchtdioden erzielt.

Gemäß der Erfindung ist vorgesehen, dass zumindest eine Leiterbahn, welche eine Leiterbahn zwischen, also elektrisch in der Reihenschaltung zwischen den Leuchtdioden, ist, eine Leiterbahnfläche auf der Vorderseite der Leiterplatte aufweist, welche um ein Vielfaches größer ist als eine jeweilige, von den Leuchtdioden auf der Vorderseite der Leiterplatte eingenommene Leuchtdiodengrundfläche. Insbesondere kann die Leiterbahnfläche um zumindest ein Fünffaches, zumindest ein Zehnfaches oder zumindest ein Zwanzigfaches größer sein als die Leuchtdiodengrundfläche. Dies kann insbesondere für alle Leiterbahnen zwischen den Leuchtdioden gelten.

Dadurch, dass die Leiterbahnfläche um ein Vielfaches größer ist als die Grundfläche der Leuchtdiode, kann die in der Leuchtdiode generierte Wärme besonders schnell von der Leuchtdiode weggeleitet werden und an der Vorderseite der Leiterplatte eine besonders gleichförmige Wärmeverteilung erzeugt werden. Damit werden erneut Temperaturspitzen vermieden und die bereits oben genannten Vorteile verstärkt. Überdies wird so ein Übertrag der Wärme von der Leiterbahn auf die Leiterplatte und einen gegebenenfalls auf einer Rückseite der Leiterplatte angeordneten Kühlkörper verbessert.

Gemäß der Erfindung ist die Leiterbahnfläche U-förmig. Insbesondere kann die Leiterbahnfläche dabei viereckige, beispielsweise quadratische, U-Seitenschenkel sowie einen streifenförmigen U-förmigen Schenkel aufweisen. Das hat den Vorteil, dass, da die U-Seitenschenkel hierbei im Wesentlichen senkrecht zu der Längsrichtung der Reihe der Leuchtdioden angeordnet sind, die Wärme von den einzelnen Leuchtdioden besonders gut und effektiv abgeführt wird. Mit viereckigen beziehungsweise quadratischen Seitenschenkeln wird hier auch bei kürzeren U-Seitenschenkeln eine maximale Leiterbahnflächengröße erzielt, sodass die Wärmeverteilung von den Leuchtdioden fort sowie der Wärmeübertrag auf die Leiterplatte maximiert wird. Der streifenförmige, also im Vergleich zu den Seitenschenkeln in der Querrichtung senkrecht zur Längs- beziehungsweise Haupterstreckungsrichtung der Reihe dünne U-Bodenschenkel begrenzt hier den Wärmeeintrag von einem Seitenschenkel in den anderen und verhindert somit, dass zu viel Wärme von einer Leuchtdiode in Richtung der anderen Leuchtdiode geleitet wird. Der streifenförmige U-Bodenschenkel schließt sich hier vorteilhafter Weise in einem von den jeweiligen Leuchtdioden entfernten Endbereich der U-Seitenschenkel an diese an.

In einer weiteren vorteilhaften Ausführungsform ist vorgesehen, dass die Leiterbahnfläche sich in einer Querrichtung senkrecht zu einer Haupterstreckungsrichtung der Reihe, also senkrecht zur Längsrichtung der Reihe, der Leuchtdioden über zumindest 50 Prozent, insbesondere über zumindest 75 Prozent oder zumindest über 85 Prozent der Breite der Leiterplatte in der Querrichtung erstreckt. Das hat den Vorteil, dass die Wärme-Ableitkapazität von der Leuchtdiode fort maximiert wird und zugleich die Wärme-Übertragungskapazität von der Leiterbahn auf die Leiterplatte und/oder gegebenenfalls einen hinter der Leiterplatte befindlichen Kühlkörper maximiert wird. Auch dies erhöht wieder Lebensdauer und Effizienz der Lichterzeugungsvorrichtung.

In einer besonders vorteilhaften Ausführungsform ist vorgesehen, dass die Leiterbahnfläche sich in der Haupterstreckungsrichtung der Reihe der Leuchtdioden beidseitig über das Ausmaß eines Gehäuses beziehungsweise über das Gehäuse der Leuchtdiode hinaus erstreckt, insbesondere zumindest an der mit der Leuchtdiode elektrisch verbundenen Seite der Leiterbahn oder der Leiterbahnfläche. Das hat den Vorteil, dass die Fläche der Leiterbahn innerhalb eines vorgegebenen Abstands zu der Leuchtdiode als Wärmequelle jeweils maximal vergrößert wird, sodass das Ableiten und Verteilen der Wärme von der Leuchtdiode auf die Leiterbahn optimiert ist.

In einer anderen vorteilhaften Ausführungsform ist vorgesehen, dass auf einer zu der Vorderseite der Leiterplatte entgegengesetzt orientierten Rückseite der Leiterplatte ein Kühlkörper thermisch zu der Leiterplatte gekoppelt angeordnet ist. Das hat den Vorteil, dass die über die Leiterbahnen verteilte Abwärme der Leuchtdioden besonders gut durch die Leiterplatte hindurch weitergeführt werden kann.

Insbesondere kann hier zu einer verbesserten Wärmeabfuhr aus den Leiterbahnen die Leiterplatte beispielsweise einen Alukern aufweisen. Auch kann die Leiterplatte zwischen zumindest einer Leiterbahn und dem Kühlkörper einen oder mehrere Kanäle aufweisen, welche mit einem elektrisch isolierenden, thermisch besser als die Leiterplatte leitfähigen Material gefüllt sind. Somit kann die thermische Kopplung zwischen der zumindest einen Leiterbahn und Kühlkörper nochmals verbessert werden.

In einer weiteren vorteilhaften Ausführungsform ist vorgesehen, dass die Leuchtdioden jeweils eine optische Hauptachse haben, welche im Wesentlichen senkrecht zur Vorderseite der Leiterplatte orientiert ist. Die optische Hauptachse entspricht hier einer Hauptaustrittsrichtung eines Lichtes der jeweiligen Leuchtdiode aus der Leuchtdiode. Die Leuchtdioden haben hier auch ein Gehäuse mit einer im Wesentlichen parallel zur optischen Hauptachse verlaufenden ersten Außenseite und mit einer der ersten Außenseite diametral gegenüberliegenden, im Wesentlichen parallel zur optischen Hauptachse verlaufenden zweiten Außenseite. Dabei ist die erste Außenseite des Gehäuses in einem geringeren Abstand von der optischen Hauptachse angeordnet als die zweite Außenseite des Gehäuses. Das Gehäuse ist somit für eine gegebene Außenkontur des Gehäuses in einer Ebene parallel zu der Vorderseite der Leiterplatte ungleichmäßig um die optische Hauptachse angeordnet. Das hat den Vorteil, dass so durch geschicktes Anordnen der Leuchtdioden die Abmessungen an verschiedene Bedingungen oder Effekte angepasst werden können.

Die optischen Achsen der Leuchtdioden können hier äquidistant angeordnet sein in der Reihe, was eine besonders homogene Ausleuchtung zur Folge hat, wie es für eine Kopf-oben-Anzeige gewünscht ist. Auch kann es sich bei den Leuchtdioden insbesondere um baugleiche Leuchtdioden handeln.

So kann hier vorgesehen sein, dass die ersten Außenseiten der Gehäuse der ersten und der letzten Leuchtdiode in der Reihe entgegengesetzt und voneinander wegweisend orientiert sind. Das hat den Vorteil, dass bei einem gegebenen Abstand der optischen Hauptachsen der ersten und der letzten Leuchtdiode der Gesamtabstand der nach außen von der Reihe der Leuchtdioden in Längsrichtung orientierten Außenseiten minimiert ist. Somit kann Bauraum gespart werden und beispielsweise weitere Elemente wie ein Reflektor besonders nah an den optischen Hauptachsen der Leuchtdioden angeordnet werden, was erneut sowohl thermische Vorteile als auch Vorteile bezüglich einer homogeneren Bündelung des Lichts der Leuchtdioden durch den Reflektor ermöglicht.

In einer weiteren Ausführungsform kann vorgesehen sein, dass zwei erste Außenseiten von mittleren Leuchtdioden, also von Leuchtdioden, welche bei mehr als drei Leuchtdioden in der Reihe nicht am Ende der Reihe angeordnet sind, in der Reihe entgegengesetzt und aufeinander zuweisend orientiert sind. Dabei sind die mittleren Leuchtdioden insbesondere die beiden Leuchtdioden, welche zentral in der Mitte, also der geometrischen Mitte in einer durch die Reihe verlaufenden Gerade, angeordnet sind. Das hat den Vorteil, dass zwischen den mittleren Leuchtdioden der Abstand zwischen den Außenseiten der jeweiligen Gehäuse besonders groß ist, sodass hier Platz geschaffen wird für weitere Elemente oder Bauelemente, ohne dass hierfür die optischen Hauptachsen der Leuchtdioden in ihrer Position verändert werden müssten. Dies ist besonders vorteilhaft, da die genaue Positionierung der optischen Hauptachsen für eine Inhomogenität eines erzeugten Lichtes wichtig ist, die wiederum gerade bei Kopf-oben-Anzeigen von entscheidender Bedeutung ist. Somit können unabhängig von den optischen Randbedingungen gewünschte mechanische Eigenschaften realisiert werden.

Dabei kann beispielsweise vorgesehen sein, dass in einem Bereich der Leiterplatte, welcher geometrisch zwischen den mittleren Leuchtdioden liegt, eine Zentriervorrichtung angeordnet ist. Diese kann beispielsweise einen Zentrierzapfen und/oder ein Zentrierloch umfassen. Insbesondere kann die Zentriervorrichtung auf der durch die Reihe verlaufenden Geraden angeordnet sein. Das hat den Vorteil, dass einerseits die Leuchtdioden bei einer Montage besonders genau zu einer vorgegebenen Position auf der Leiterplatte zentriert beziehungsweise positioniert werden können, da die Zentriervorrichtung in größtmöglicher Nähe zu der Reihe und den Leuchtdioden vorhanden ist. Überdies kann so die gleiche Zentriervorrichtung auch beispielsweise für ein Zentrieren eines weiteren optischen Elementes wie eines Reflektors genutzt werden. Auch hier ist die Anordnung der Zentriervorrichtung nahe, bzw. in der Reihe von Leuchtdioden besonders vorteilhaft, überdies wird die Genauigkeit durch das Nutzen der gleichen Zentrierrichtung für weitere Elemente und das Montieren der Leuchtdioden auf der Leiterplatte vergrößert.

Es kann hier auch vorgesehen sein, dass die Lichterzeugungsvorrichtung einen an der Vorderseite der Leiterplatte angeordneten Reflektor aufweist, welcher ein der Zentriervorrichtung entsprechendes Zentrierelement aufweist zum Zentrieren oder Positionieren des Reflektors relativ zur Leiterplatte. Das ergibt ebenfalls die genannten Vorteile für den Reflektor. Gerade der Reflektor sollte besonders nah und in genauer Relation zu den Leuchtdioden orientiert angeordnet sein, sodass die genannten Vorteile hier besonders günstig sind.

In einer weiteren Ausführungsform ist vorgesehen, dass die Lichterzeugungsvorrichtung einen an der Vorderseite der Leiterplatte angeordneten Reflektor aufweist, welcher zumindest ein Abstützelement zum Abstützen des Reflektors auf der Leiterplatte in einem jeweiligen, sich an die beiden ersten Außenseiten der ersten und letzten Leuchtdiode und/oder an die beiden ersten Außenseiten der beiden mittleren Leuchtdioden in geometrischer Verlängerung der Reihe beziehungsweise in der Reihe auf der Leiterplatte anschließenden Nachbarbereich aufweist. Besonders vorteilhaft ist hier ein Abstützelement zum Abstützen zwischen zwei mittleren Leuchtdioden, welche in der genauen Mitte der Reihe angeordnet sind. Das hat den Vorteil, dass der Reflektor, welcher besonders genau relativ zu den Leuchtdioden positioniert werden muss, um die Lichtqualität in der Kopf-oben-Anzeige zu optimieren, sehr nah an den Leuchtdioden als Lichtquellen abgestützt werden kann, sodass ein Verformen und dergleichen des Reflektors, welches die Qualität des Lichtes in der Kopf-oben-Anzeige verschlechtern könnte, verhindert oder vermindert wird.

Dabei ist besonders vorteilhaft, wenn an der Rückseite der Leiterplatte, wie weiter oben beschrieben, ein Kühlkörper angeordnet ist und der Reflektor an dem Kühlkörper befestigt ist sowie die Leiterplatte durch das zumindest eine Abstandselement mit ihrer Rückseite an den Kühlkörper gepresst ist. Dadurch, dass der Reflektor an dem Kühlkörper befestigt ist, kann durch das Abstützelement verhindert werden, dass sich beispielsweise Luftspalte zwischen der Rückseite der Leiterplatte und dem Kühlkörper ergeben, welche für die Wärmeabfuhr von den Leiterbahnen zu dem Kühlkörper ungünstig sind. Es ergibt sich hier bezüglich der Leiterplatte somit eine Sandwichstruktur aus Reflektor, Leiterplatte und Kühlkörper.

Die Erfindung betrifft auch eine Kopf-oben-Anzeigevorrichtung mit einer Lichterzeugungsvorrichtung nach einer der genannten Ausführungsformen. Auch ein Kraftfahrzeug mit einer solchen Kopf-oben-Anzeigevorrichtung ist von der Erfindung umfasst.

Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind, wie im beigefügten Anspruchssatz definiert. Es sind auch Ausführungen und Merkmalskombinationen als offenbart anzusehen, die somit nicht alle Merkmale eines ursprünglich formulierten unabhängigen Anspruchs aufweisen. Es sind darüber hinaus Ausführungen und Merkmalskombinationen, insbesondere durch die oben dargelegten Ausführungen, als offenbart anzusehen, die über die in den Rückbezügen der Ansprüche dargelegten Merkmalskombinationen hinausgehen oder abweichen.

Ausführungsbeispiele der Erfindung werden nachfolgend anhand schematischer Zeichnungen näher erläutert.

Dabei zeigen:
- Fig. 1: eine Draufsicht auf eine Vorderseite einer beispielhafte Ausführungsform einer Lichterzeugungsvorrichtung;
- Fig. 2: eine Schnittansicht einer weiteren beispielhaften Ausführungsform einer Lichterzeugungsvorrichtung mit einer senkrecht zur Vorderseite entlang der Haupterstreckungsrichtung der Reihe verlaufenden Schnittebene;
- Fig. 3: eine perspektivische Ansicht einer beispielhaften Ausführungsform einer Kopf-oben-Anzeige; und
- Fig. 4: eine symbolische Darstellung eines Kraftfahrzeugs mit einer weiteren Ausführungsform einer Kopf-oben-Anzeige.

Gleiche oder funktionsgleiche Merkmale sind dabei in den Figuren mit dem gleichen Bezugszeichen versehen.

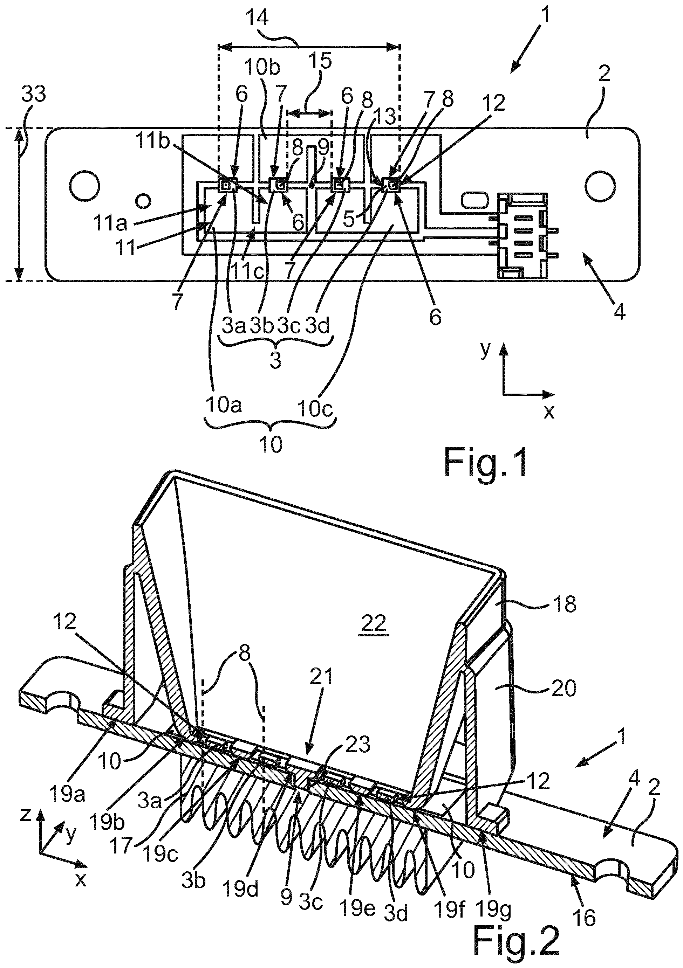

In Fig. 1 ist eine beispielhafte Ausführungsform einer Lichterzeugungsvorrichtung von einer Vorderseite gezeigt. Die Lichterzeugungsvorrichtung 1 hat dabei eine vorliegend im Wesentlichen rechteckige Leiterplatte 2 und zumindest zwei, hier vier, Leuchtdioden 3, welche auf der Vorderseite 4 der Leiterplatte 2 angebracht sind, zum Beispiel verlötet sind. Die Leuchtdioden 3 weisen dabei jeweils ein Gehäuse 5 mit einer Kathodenseite 6 und einer Anodenseite 7 auf. Der Übersichtlichkeit dienend ist nur eine der Leuchtdioden 3 mit dem jeweiligen Bezugszeichen versehen. Die Orientierung der jeweiligen Leuchtdiode 3 wird dabei durch die Ausrichtung der Kathoden- beziehungsweise Anodenseite 6, 7 bestimmt. Die Leuchtdioden 3 weisen jeweils auch eine optische Hauptachse 8 auf, welche die Hauptaustrittsrichtung eines von der jeweiligen Leuchtdiode 3 erzeugten Lichtes bestimmt und welche vorliegend senkrecht zur Zeichenebene steht. Die Leiterplatte 2 weist hier auch eine Zentriervorrichtung 9 auf, welche beispielsweise als Zentrierloch ausgeführt sein kann. Die Darstellung ist hier in der Fig. 1 symbolisch. Die Leiterplatte 2 verfügt hier zur Stromversorgung der Leuchtdioden 3 auch über einen elektrischen Anschluss.

Die Leuchtdioden 3 sind nun entlang einer Reihe, deren Haupterstreckungsrichtung vorliegend die x-Richtung und somit eine Längsrichtung der Leiterplatte 2 ist, auf der Vorderseite 4 angeordnet. Dabei sind im gezeigten Beispiel die geometrisch in der Reihe benachbarten Leuchtdioden 3 auch die elektrisch in der Reihenschaltung benachbarten Leuchtdioden 3.

Anodenseite 7 beziehungsweise Kathodenseite 6 der in der Reihenschaltung aufeinanderfolgenden Leuchtdioden 3 sind hierbei geometrisch im Wesentlichen entgegengesetzt orientiert angeordnet. Somit weist hier die Kathodenseite 6 einer Leuchtdiode 3 in positiver y-Richtung und die der benachbarten Leuchtdiode 3 jeweils in negativer y-Richtung. Für die Anodenseiten 7 gilt mutatis mutandis das Gleiche. Das heißt auch, dass bezüglich dem Begriff der Orientierung einer Leuchtdiode 3 zu einander insbesondere die Lage der Anodenseite 6 und der Kathodenseite 7 beurteilt wird und die direkt benachbarten Leuchtdiode 3 jeweils betrachtet werden. Insbesondere sind daher diesbezüglich die jeweils direkt nebeneinander angeordneten Leuchtdioden um jeweils 180°zueinander versetzt positioniert, wobei die Drehachse bezüglich dem Versatz senkrecht zur Leiterplatte 2 orientiert ist. Im Ausführungsbeispiel sind die Leuchtdioden 3 so angeordnet, dass eine gedachte Verbindung zwischen einer Anodenseite 6 und einer Kathodenseite 7 einer Leuchtdiode 3 in Breitenrichtung (y-Richtung) der Leiterplatte 2 gerichtet ist.

In der Reihenschaltung, also elektrisch zwischen den Leuchtdioden 3, sind hier jeweilige Leiterbahnen 10 auf der Vorderseite 4 der Leiterplatte 2 angeordnet, welche je eine Kathodenseite 6 einer Leuchtdiode 3 mit der Anodenseite 7 einer in der Reihenschaltung benachbarten Leuchtdiode 3 elektrisch koppeln. Die Leiterbahnen 10 können beispielsweise aus Kupfer bestehen oder Kupfer umfassen. Gemäß der Erfindung, weisen die Leiterbahnen 10 dabei vorliegend jeweils eine U-förmige Leiterbahnfläche 11 auf, welche jeweils mit hier viereckigen U-Seitenschenkeln 11a, 11b zu der hier geraden Reihe von der Leuchtdioden 3 hin orientiert sind. Ein hier streifenförmiger U-Bodenschenkel 11c ist vorliegend also jeweils an dem den Leuchtdioden 3 entfernteren Ende der U-Seitenschenkel 11a, 11b angeordnet. An den dem U-Bodenschenkel 11c entfernten Enden der U-Seitenschenkel 11a, 11b sind also vorliegend die Leuchtdioden 3 mit ihrer Anode beziehungsweise Kathode kontaktiert.

An der jeweils den Leuchtdioden 3 zugewandten Kopfseite erstrecken sich im gezeigten Beispiel die U-Seitenschenkel 11a, 11b jeweils in x-Richtung, also in Längsrichtung beziehungsweise Haupterstreckungsrichtung der Reihe über das jeweilige Gehäuse 5 der entsprechenden Leuchtdiode 3 hinaus. In einer Querrichtung senkrecht zur Haupterstreckungsrichtung der Reihe verlaufen die Leiterbahnflächen 11 zumindest hier mit ihren U-Seitenschenkeln 11a, 11b über mehr als 50 Prozent der Breite der Leiterplatte 2 in der Querrichtung.

Die Gehäuse 5 der Leuchtdioden 3, die beispielhaft für die weitere Erläuterung in der Reihe als Leuchtdioden 3a, 3b, 3c und 3d bezeichnet sind, weisen hier im gezeigten Beispiel eine erste Außenseite 12 auf, welche parallel zur optischen Hauptachse 8 verläuft, sowie eine zweite Außenseite 13, die ebenfalls parallel zur optischen Hauptachse 8 verläuft, jedoch bezüglich der optischen Hauptachse 8 der ersten Außenseite 12 diametral gegenüberliegt. Im gezeigten Beispiel sind nun die ersten Außenseiten 12 der ersten Leuchtdiode 3a und der letzten Leuchtdiode 3d in der Reihe entgegengesetzt und voneinander wegweisend jeweils in positiver und negativer x-Richtung orientiert. Des Weiteren sind die Leuchtdioden 3a bis 3d asymmetrisch ausgebildet. Das bedeutet, dass die Hauptachse 8 mit unterschiedlichen Abständen zu den Außenseiten 12 und 13 ausgebildet ist. Da die ersten Außenseiten 12 zu der optischen Hauptachse 8 daher jeweils einen geringeren Abstand aufweisen als die zweiten Außenseiten 13, wird so ein Gesamtabstand 14 der ersten Außenseiten 12 der beiden Leuchtdioden 3a, 3d bei einem vorgegebenen Abstand der zu den beiden Leuchtdioden 3a, 3d gehörigen optischen Hauptachsen 8 minimiert. Damit wird ein erforderlicher Raumbedarf für die Reihe minimiert und weitere Elemente können besonders nah an die Reihe und deren optischen Achsen 8 herangebaut werden.

Im gezeigten Beispiel sind die beiden mittleren Leuchtdioden 3b, 3c, welche vorliegend auch in der Mitte der Reihe beziehungsweise in der geometrischen Mitte der Reihe angeordnet sind, mit ihren ersten Außenseiten 12 aufeinander zuweisend orientiert angeordnet. Dadurch ergibt sich zwischen den beiden Gehäusen 5 der beiden Leuchtdioden 3b, 3c ein maximierter, im Vergleich zu anderen Anordnungen vergrößerter Abstand 15. Somit kann der Zwischenraum zwischen den Leuchtdioden 3b, 3c besser für weitere Zwecke genutzt werden.

Im gezeigten Beispiel ist hier die Zentriervorrichtung 9 in der Reihe mittig zwischen den beiden Leuchtdioden 3b, 3c angeordnet. Auch kann der vergrößerte Abstand 15 dazu dienen, weitere Elemente an der Leiterplatte stabil abzustützen.

Fig. 2 zeigt eine perspektivische Schnittansicht durch eine beispielhafte Ausführungsform einer Lichterzeugungsvorrichtung in einer Ebene senkrecht zu der Vorderseite und parallel zur Haupterstreckungsrichtung der Reihe. An einer der Vorderseite 4 entgegengesetzt orientierten Rückseite 16 der Leiterplatte 2 ist hier im gezeigten Beispiel ein Kühlkörper 17 angeordnet.

Neben den aus Fig. 1 bekannten Leuchtdioden 3 weist die Leiterplatte 2 vorliegend eine als Zentrierloch ausgeführte Zentriervorrichtung 9 auf. Diese ist hier zwischen den mittleren Leuchtdioden 3b und 3c in der Reihe der Leuchtdioden 3 angeordnet.

Als zusätzliches optisches Element verfügt die Lichterzeugungsvorrichtung 1 im gezeigten Beispiel auch über einen Reflektor 18, welcher an der Vorderseite 4 der Leiterplatte 2 angeordnet ist. Dieser Reflektor 18 ist an Abstützflächen 19 (19a bis 19g) an der Leiterplatte 2 auf deren Vorderseite 4 abgestützt. Zwei der Abstützflächen 19a, 19g sind dabei zur seitlichen Stabilisierung einem umlaufenden Kragen 20 des Reflektors 18 zugeordnet, die weiteren Abstützflächen 19b bis 19f sind einer der Leiterplatte 2 angrenzenden Rückseite 21 einer Reflexionsfläche 22 des Reflektors 18 zugeordnet. Die zwei Abstützflächen 19b und 19f führen dabei die reflektierende Oberfläche 22 nah an die optischen Hauptachsen 8 der ersten und letzten Leuchtdiode 3a, 3d heran, was durch die hier vorliegende, nach außen, also voneinander weg gerichtete Orientierung der ersten Außenflächen 12 der Leuchtdioden 3a und 3d möglich ist. Vorliegend ist in der Reihe eine weitere Abstützfläche 19c zwischen den Leuchtdioden 3a und 3b, eine zentrale Abstützfläche 19d zwischen den mittleren Leuchtdioden 3b und 3c sowie eine dritte Abstützfläche 19e zwischen den Leuchtdioden 3c und 3d angeordnet.

Da hier die mittleren Leuchtdioden 3b und 3c mit ihren ersten Außenflächen 12 zu einem Zentrum der Reihe hin orientiert sind, ergibt sich für die dritte Abstützfläche 19d ein besonders großer Bauraum, wodurch sich wiederum eine stabile Abstützung des Reflektors 18 an der Leiterplatte 2 ergibt. Im gezeigten Beispiel wird dieser Bauraum auch durch die Zentriervorrichtung 9 genützt, welcher seitens des Reflektors 18 ein Zentrierzapfen 23 zugeordnet ist. Entsprechend kann die Zentriervorrichtung 9 sowohl zum Zentrieren und Positionieren des Reflektors 18 als auch der Leiterplatte beziehungsweise der Leuchtdioden 3 bei der Montage dienen.

Durch die Abstützflächen 19a bis 19g, insbesondere durch die mittleren Abstützflächen 19b bis 19f, kann die Leiterplatte 2 im Bereich der Leiterbahnen 10 gegen den Kühlkörper 17 gepresst werden. Dadurch ergibt sich eine verbesserte Wärmeabfuhr. Überdies kann durch die Abstützflächen der Reflektor 18 stabilisiert und präzise in seiner Position gehalten werden, sodass hier die Genauigkeit der Lichterzeugungsvorrichtung 1 verbessert ist.

Der Reflektor 18 kann auch zum Halten an der Leiterplatte 2 mit dem Kühlkörper 17 verbunden, beispielsweise verschraubt, werden, sodass dann nach Art eines Sandwiches ein guter thermischer Kontakt zwischen Kühlkörper 17 und Leiterplatte 2 erreicht ist.

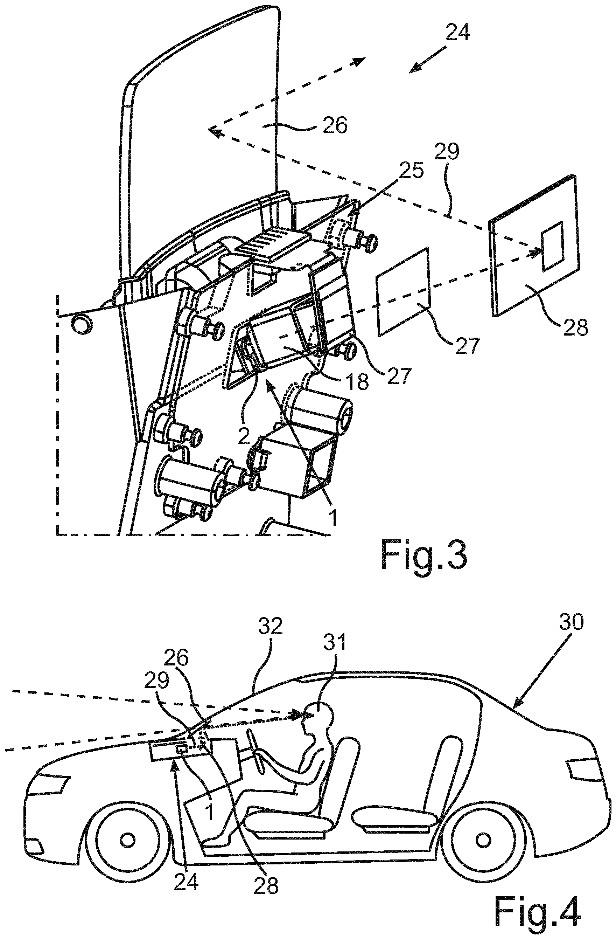

Fig. 3 zeigt eine perspektivische Ansicht einer beispielhaften Kopf-oben-Anzeige 24. Die Kopf-oben-Anzeige 24 verfügt im gezeigten Beispiel über eine beispielhafte Ausführungsform einer Lichterzeugungsvorrichtung 1 mit einer Leiterplatte 2 und einem Reflektor 18, welcher an der Vorderseite 4 der Leiterplatte 2 angeordnet ist. Die Kopf-oben-Anzeige 24 weist hier auch eine zweite Leiterplatte 25 auf, auf welcher beispielsweise eine Steuerelektronik und dergleichen angebracht ist. Die beiden Leiterplatten 2, 25 sind vorliegend gegeneinander verkippt. Die Kopf-oben-Anzeige 24 verfügt hier auch über einen Spiegel 26, der auch aufgrund des Typs der Kopf-oben-Anzeige 24 als Kombinierspiegel bezeichnet wird, sowie über weitere optische Komponenten 27 und einen Spiegel 28, welche in einem optischen Weg 29 eines durch die Lichterzeugungsvorrichtung 1 erzeugten Lichtes angeordnet sind. Der Spiegel 26 ist der im Projektionsstrahlengang des zu erzeugenden virtuellen Bilds der letzte Spiegel, mit welchem das Bild dann direkt zum Beobachter reflektiert wird.

Fig. 4 zeigt eine Ansicht eines beispielhaften Kraftfahrzeugs 30 mit einer beispielhaften Ausführungsform einer Kopf-oben-Anzeige 24. Das Kraftfahrzeug 30 weist hier eine beispielhaft in einem Armaturenbrett des Kraftfahrzeugs angeordnete Kopf-oben-Anzeige 24 auf, welche mit der Lichterzeugungsvorrichtung 1 über den Spiegel 28 und den Kombinierspiegel 26 entlang eines optischen Weges 29 ein Licht in das Auge eines Fahrers 31 projiziert. Dieses Licht wird dabei mit einem durch die zum Spiegel 26 separate Windschutzscheibe 32 fallenden Licht aus einer Umgebung des Kraftfahrzeugs 30 überlagert.

## Patentansprüche

1. Lichterzeugungsvorrichtung (1) für eine Kopf-oben-Anzeige (24) eines Kraftfahrzeugs (30), mit
- einer Leiterplatte (2); und
- zumindest zwei mittels zumindest einer Leiterbahn (10, 10a, 10b, 10c) in Reihe geschalteten, auf einer Vorderseite (4) der Leiterplatte (2) in einer Reihe angeordneten Leuchtdioden (3, 3a, 3b, 3c, 3d), deren jeweilige Orientierung auf der Vorderseite (4) durch eine Ausrichtung einer Kathodenseite (6) und einer Anodenseite (7) der jeweiligen Leuchtdiode (3, 3a, 3b, 3c, 3d) bestimmt ist, **dadurch gekennzeichnet, dass**
die jeweils in der Reihenschaltung aufeinander folgenden Leuchtdioden (3, 3a, 3b, 3c, 3d) geometrisch im Wesentlichen entgegengesetzt orientiert angeordnet sind, wobei zumindest eine Leiterbahn (10, 10a, 10b, 10c), welche eine Leiterbahn (10, 10a, 10b, 10c) zwischen den Leuchtdioden (3, 3a, 3b, 3c, 3d) ist, eine Leiterbahnfläche (11) auf der Vorderseite (4) der Leiterplatte (2) aufweist, die um ein Vielfaches größer ist als eine jeweilige von den Leuchtdioden (3a, 3b, 3c, 3d) auf der Vorderseite (4) der Leiterplatte (2) eingenommene Leuchtdioden-Grundfläche, insbesondere um zumindest ein 5-faches, 10-faches oder 20-faches und die Leiterbahnfläche (11) U-Förmig ist, insbesondere mit viereckigen U-Seitenschenkeln (11a, 11b) und einem streifenförmigen U-Bodenschenkel (11c).

2. Lichterzeugungsvorrichtung (1) nach Anspruch 1,
**dadurch gekennzeichnet, dass**
die Leiterbahnfläche (11) sich in einer Querrichtung senkrecht zu einer Haupterstreckungsrichtung der Reihe der Leuchtdioden (3, 3a, 3b, 3c, 3d) über zumindest 50%, insbesondere über zumindest 75%, der Breite (33) der Leiterplatte (2) in der Querrichtung erstreckt.

3. Lichterzeugungsvorrichtung (1) nach Anspruch 1 oder 2,
**dadurch gekennzeichnet, dass**
die Leiterbahnfläche (11) sich in der Haupterstreckungsrichtung der Reihe der Leuchtdioden (3, 3a, 3b, 3c, 3d) beidseits über das Ausmaß zumindest eines Gehäuses (5) einer Leuchtdiode (3a, 3b, 3c, 3d) hinaus erstreckt, insbesondere zumindest an der mit einerLeuchtdiode (3a, 3b, 3c, 3d) elektrisch verbundenen Seite.

4. Lichterzeugungsvorrichtung (1) nach einem der vorhergehenden Ansprüche,
**dadurch gekennzeichnet, dass**
auf einer zu der Vorderseite (4) der Leiterplatte (2) entgegengesetzt orientierten Rückseite (16) der Leiterplatte (2) ein Kühlkörper (17) angeordnet ist.

5. Lichterzeugungsvorrichtung (1) nach einem der vorhergehenden Ansprüche,
**dadurch gekennzeichnet, dass**
die Leuchtdioden (3, 3a, 3b, 3c, 3d) jeweils eine optische Hauptachse (8) haben und jeweilige Gehäuse (5) der Leuchtdioden (3, 3a, 3b, 3c, 3d) jeweils eine im Wesentlichen parallel zur optischen Hauptachse (8) verlaufende erste Außenseite (12) und eine der ersten Außenseite (12) diametral gegenüberliegende, im Wesentlichen parallel zur optischen Hauptachse (8) verlaufende zweite Außenseite (13) aufweisen, wobei die erste Außenseite (12) eines Gehäuses (5) in einem geringeren Abstand von der optischen Hauptachse (8) angeordnet ist als die zweite Außenseite (13) des Gehäuses (5).

6. Lichterzeugungsvorrichtung (1) nach Anspruch 5,
**dadurch gekennzeichnet, dass**
die ersten Außenseiten (12) der Gehäuse (5) der ersten und der letzten Leuchtdiode (3a, 3d) in der Reihe entgegengesetzt und voneinander weg weisend orientiert sind.

7. Lichterzeugungsvorrichtung (1) nach Anspruch 5 oder 6,
**dadurch gekennzeichnet, dass**
zwei erste Außenseiten (12) von mittleren Leuchtdioden (3b, 3c) in der Reihe entgegengesetzt und aufeinander zuweisend orientiert sind, wobei die mittleren Leuchtdioden (3b, 3c) insbesondere die beiden Leuchtdioden (3b, 3c) in der Mitte der Reihe sind.

8. Lichterzeugungsvorrichtung (1) nach Anspruch 7,
**dadurch gekennzeichnet, dass**
in einem Bereich der Leiterplatte (2) zwischen den mittleren Leuchtdioden (3b, 3c) eine Zentriervorrichtung (9) angeordnet ist, insbesondere ein Zentrierzapfen und/oder ein Zentrierloch.

9. Lichterzeugungsvorrichtung (1) nach Anspruch 8,
**dadurch gekennzeichnet, dass**
die Lichterzeugungsvorrichtung (1) einen an der Vorderseite (4) der Leiterplatte (2) angeordneten Reflektor (18) aufweist, welcher ein der Zentriervorrichtung (9) entsprechendes Zentrierelement (23) aufweist zum Zentrieren des Reflektors (18) relativ zur Leiterplatte (2).

10. Lichterzeugungsvorrichtung (1) nach einem der Ansprüche 6 bis 9,
**dadurch gekennzeichnet, dass**
die Lichterzeugungsvorrichtung (1) einen an der Vorderseite (4) der Leiterplatte (2) angeordneten Reflektor (18) aufweist, welcher zumindest ein Abstützelement (19, 19a-19g) zum Abstützen des Reflektors (18) auf der Leiterplatte (2) in einem jeweiligen, sich an die beiden ersten Außenseiten (12) der ersten und letzten Leuchtdiode (3a, 3d) und/oder an die beiden ersten Außenseiten (12) der beiden mittleren Leuchtdioden (3b, 3c) auf der Leiterplatte (2) anschließenden Nachbarbereich.

11. Lichterzeugungsvorrichtung (1) nach der Anspruch 4 und 10,
**dadurch gekennzeichnet, dass**
der Reflektor (18) an dem Kühlkörper (17) befestigt ist und die Leiterplatte (2) durch das zumindest eine Abstützelement (19, 19a-19g) mit Ihrer Rückseite (16) an den Kühlkörper (17) gepresst ist.

12. Kopf-oben-Anzeige (24) mit einer Lichterzeugungsvorrichtung (1) nach einem der vorhergehenden Ansprüche.

13. Kraftfahrzeug (30) mit einer Kopf-oben-Anzeige (24) nach Anspruch 12.

## Claims

1. Light-generating device (1) for a head-up display (24) of a motor vehicle (30), having
- a printed circuit board (2); and
- at least two light-emitting diodes (3, 3a, 3b, 3c, 3d) which are connected in series by means of at least one conductor track (10, 10a, 10b, 10c) and arranged in a row on a front side (4) of the printed circuit board (2) and whose respective orientation on the front side (4) is determined by an alignment of a cathode side (6) and an anode side (7) of the respective light emitting diode (3, 3a, 3b, 3c, 3d),
**characterized in that**
the light-emitting diodes (3, 3a, 3b, 3c, 3d) which follow each other in the series circuit are arranged substantially in opposite geometric orientations, wherein at least one conductor track (10, 10a, 10b, 10c), which is a conductor track (10, 10a, 10b, 10c) between the light-emitting diodes (3, 3a, 3b, 3c, 3d), has a conductor track surface (11) on the front side (4) of the printed circuit board (2) that is many times larger, in particular at least 5 times, 10 times or 20 times larger, than a respective light-emitting diode base area taken up by the light-emitting diodes (3a, 3b, 3c, 3d) on the front side (4) of the printed circuit board (2), and the conductor track surface (11) is U-shaped, in particular, with quadrilateral U-shaped side limbs (11a, 11b) and a strip-shaped U-shaped base limb (11c).

2. Light-generating device (1) according to Claim 1,
**characterized in that**
in a transverse direction perpendicular to a main extension direction of the row of light-emitting diodes (3, 3a, 3b, 3c, 3d), the conductor track surface (11) extends over at least 50%, in particular over at least 75%, of the width (33) of the printed circuit board (2) in the transverse direction.

3. Light-generating device (1) according to Claim 1 or 2,
**characterized in that**
in the main extension direction of the row of light-emitting diodes (3, 3a, 3b, 3c, 3d), the conductor track surface (11) extends beyond the extent of at least one housing (5) of a light-emitting diode (3a, 3b, 3c, 3d) on both sides, in particular at least on the side electrically connected to a light-emitting diode (3a, 3b, 3c, 3d).

4. Light-generating device (1) according to any of the preceding claims,
**characterized in that**
a heatsink (17) is arranged on a back side (16) of the printed circuit board (2) that is opposite to the front side (4) of the printed circuit board (2).

5. Light-generating device (1) according to any of the preceding claims,
**characterized in that**
the light-emitting diodes (3, 3a, 3b, 3c, 3d) each have an optical main axis (8) and respective housings (5) of the light-emitting diodes (3, 3a, 3b, 3c, 3d) each have a first external side (12) that extends substantially parallel to the optical main axis (8) and a second external side (13) that is diametrically opposite to the first external side (12) and extends substantially parallel to the optical main axis (8), wherein the first external side (12) of a housing (5) is arranged at a shorter distance from the optical main axis (8) than the second external side (13) of the housing (5).

6. Light-generating device (1) according to Claim 5,
**characterized in that**
the first external sides (12) of the housings (5) of the first and last light-emitting diodes (3a, 3d) in the row are in the opposite sense and oriented in a manner facing away from each other.

7. Light-generating device (1) according to Claim 5 or 6,
**characterized in that**
two first external sides (12) of central light-emitting diodes (3b, 3c) in the row are in the opposite sense and oriented in a manner facing towards each other, wherein the central light-emitting diodes (3b, 3c), in particular the two light-emitting diodes (3b, 3c), are in the centre of the row.

8. Light-generating device (1) according to Claim 7,
**characterized in that**
a centring device (9), in particular a centring pin and/or a centring hole, is arranged in a region of the printed circuit board (2) between the central light-emitting diodes (3b, 3c).

9. Light-generating device (1) according to Claim 8,
**characterized in that**
the light-generating device (1) comprises a reflector (18) that is arranged on the front side (4) of the printed circuit board (2) and comprises a centring element (23) corresponding to the centring device (9) for centring the reflector (18) relative to the printed circuit board (2).

10. Light-generating device (1) according to any of Claims 6 to 9,
**characterized in that**
the light-generating device (1) comprises a reflector (18) that is arranged on the front side (4) of the printed circuit board (2) and at least one support element (19, 19a-19g) for supporting the reflector (18) on the printed circuit board (2) in a respective adjacent region on the printed circuit board (2) that adjoins the two first external sides (12) of the first and last light-emitting diodes (3a, 3d) and/or the two first external sides (12) of the two central light-emitting diodes (3b, 3c).

11. Light-generating device (1) according to Claims 4 and 10,
**characterized in that**
the reflector (18) is secured to the heatsink (17), and the back side (16) of the printed circuit board (2) is pressed against the heatsink (17) by the at least one support element (19, 19a-19g).

12. Head-up display (24) having a light-generating device (1) according to any of the preceding claims.

13. Motor vehicle (30) having a head-up display (24) according to Claim 12.

## Revendications

1. Dispositif de génération de lumière (1) pour un afficheur tête haute (24) d'un véhicule automobile (30), comprenant
- une carte à circuit imprimé (2) ; et
- au moins deux diodes électroluminescentes (3, 3a, 3b, 3c, 3d) branchées en série au moyen d'au moins une piste conductrice (10, 10a, 10b, 10c) et disposées en une rangée sur un côté avant (4) de la carte à circuit imprimé (2), dont l'orientation respective sur le côté avant (4) est déterminée par un alignement d'un côté cathode (6) et d'un côté anode (7) de la diode électroluminescente (3, 3a, 3b, 3c, 3d) respective,
**caractérisé en ce que**
les diodes électroluminescentes (3, 3a, 3b, 3c, 3d) qui se suivent respectivement dans le branchement en série sont disposées géométriquement en étant orientées sensiblement en opposition, au moins une piste conductrice (10, 10a, 10b, 10c), laquelle est une piste conductrice (10, 10a, 10b, 10c) entre les diodes électroluminescentes (3, 3a, 3b, 3c, 3d), présentant une surface de piste conductrice (11) sur le côté avant (4) de la carte à circuit imprimé (2), qui est plusieurs fois plus grande, notamment 5 fois, 10 fois ou 20 fois, qu'une surface de base de diode électroluminescente respective occupée par les diodes électroluminescentes (3a, 3b, 3c, 3d) sur le côté avant (4) de la carte à circuit imprimé (2), et la surface de piste conductrice (11) est en forme de U, notamment avec des branches latérales de U quadrangulaires (11a, 11b) et une branche de fond de U en forme de bande (11c).

2. Dispositif de génération de lumière (1) selon la revendication 1,
**caractérisé en ce que**
la surface de piste conductrice (11) s'étend dans une direction transversale perpendiculaire à une direction d'extension principale de la rangée de diodes électroluminescentes (3, 3a, 3b, 3c, 3d) sur au moins 50 %, notamment sur au moins 75 %, de la largeur (33) de la carte à circuit imprimé (2) dans la direction transversale.

3. Dispositif de génération de lumière (1) selon la revendication 1 ou 2,
**caractérisé en ce que**
la surface de piste conductrice (11) s'étend dans la direction d'extension principale de la rangée de diodes électroluminescentes (3, 3a, 3b, 3c, 3d) des deux côtés au-delà de l'étendue d'au moins un boîtier (5) d'une diode électroluminescente (3a, 3b, 3c, 3d), notamment au moins sur le côté relié électriquement à une diode électroluminescente (3a, 3b, 3c, 3d).

4. Dispositif de génération de lumière (1) selon l'une des revendications précédentes,
**caractérisé en ce que**
un dissipateur de chaleur (17) est disposé sur un côté arrière (16) de la carte à circuit imprimé (2) orienté à l'opposé du côté avant (4) de la carte à circuit imprimé (2).

5. Dispositif de génération de lumière (1) selon l'une des revendications précédentes,
**caractérisé en ce que**
les diodes électroluminescentes (3, 3a, 3b, 3c, 3d) ont chacune un axe optique principal (8) et les boîtiers (5) respectifs des diodes électroluminescentes (3, 3a, 3b, 3c, 3d) possèdent chacun un premier côté extérieur (12), qui suit un tracé sensiblement parallèle à l'axe optique principal (8), et un deuxième côté extérieur (13), diamétralement opposé au premier côté extérieur (12) et qui suit un tracé sensiblement parallèle à l'axe optique principal (8), le premier côté extérieur (12) d'un boîtier (5) étant disposé à une distance plus faible de l'axe optique principal (8) que le deuxième côté extérieur (13) du boîtier (5).

6. Dispositif de génération de lumière (1) selon la revendication 5,
**caractérisé en ce que**
les premiers côtés extérieurs (12) des boîtiers (5) de la première et de la dernière diode électroluminescente (3a, 3d) sont orientés dans la rangée de manière opposée et en s'éloignant l'un de l'autre.

7. Dispositif de génération de lumière (1) selon la revendication 5 ou 6,
**caractérisé en ce que**
deux premiers côtés extérieurs (12) de diodes électroluminescentes centrales (3b, 3c) dans la rangée sont orientés de manière opposée et en se faisant mutuellement face, les diodes électroluminescentes centrales (3b, 3c) étant notamment les deux diodes électroluminescentes (3b, 3c) au milieu de la rangée.

8. Dispositif de génération de lumière (1) selon la revendication 7,
**caractérisé en ce que**
un dispositif de centrage (9) est disposé dans une zone de la carte à circuit imprimé (2) entre les diodes électroluminescentes centrales (3b, 3c), notamment un tenon de centrage et/ou un trou de centrage.

9. Dispositif de génération de lumière (1) selon la revendication 8,
**caractérisé en ce que**
le dispositif de génération de lumière (1) possède un réflecteur (18) disposé sur le côté avant (4) de la carte à circuit imprimé (2), lequel possède un élément de centrage (23) correspondant au dispositif de centrage (9) pour centrer le réflecteur (18) par rapport à la carte à circuit imprimé (2).

10. Dispositif de génération de lumière (1) selon l'une des revendications 6 à 9,
**caractérisé en ce que**
le dispositif de génération de lumière (1) possède un réflecteur (18) disposé sur le côté avant (4) de la carte à circuit imprimé (2), lequel au moins un élément d'appui (19, 19a-19g) servant à l'appui du réflecteur (18) sur la carte à circuit imprimé (2) dans une zone voisine respective qui se rattache aux deux premiers côtés extérieurs (12) de la première et de la dernière diode électroluminescente (3a, 3d) et/ou aux deux premiers côtés extérieurs (12) des deux diodes électroluminescentes centrales (3b, 3c) sur la carte à circuit imprimé (2).

11. Dispositif de génération de lumière (1) selon les revendications 4 et 10,
**caractérisé en ce que**
le réflecteur (18) est fixé au dissipateur de chaleur (17) et la carte à circuit imprimé (2) est pressée par son côté arrière (16) contre le dissipateur de chaleur (17) par l'au moins un élément d'appui (19, 19a-19g).

12. Afficheur tête haute (24) comprenant un dispositif de génération de lumière (1) selon l'une des revendications précédentes.

13. Véhicule automobile (30) comprenant un afficheur tête haute (24) selon la revendication 12.
